# DEMANDE DE BREVET EUROPEEN

(11) **EP 0 877 539 A1**
(43) Date de publication de la demande: **11.11.1998**
(21) Numéro de dépôt: 98500095.9
(22) Date de dépôt: 21.04.1998
(51) Int. Cl.: H05K 3/34, H01R 4/02

(54) **Améliorations dans les procédés de fabrication de boîtes de services et de leurs parties**

(30) Priorité: 09.05.1997 ES 9700994
(71) Demandeur: MECANISMOS AUXILIARES INDUSTRIALES S.A. M.A.I.S.A., E-43800 Valls, Tarragona (ES)
(72) Inventeur: Cubero Pintel, Jose Antonio, 43800 Valls (Tarragona) (ES)
(74) Mandataire: Morgades y Manonelles, Juan Antonio

(57) **Abrégé**

Pour obtenir une amélioration de la soudure, en particulier pour les composants transversaux (13) soudés sur les deux faces d'un circuit imprimé (10), il faut recourir à des procédés de soudure de différentes caractéristiques sur chacune des extrémités des composants (13), de sorte que les deux soudures (14a,14b) ne se voient pas qualitativement affectées entre elles. Pour en éviter les conséquences, une solution a été trouvée et elle consiste à utiliser des alliages de soudure (14a,14b) avec des points de soudure différents pour chacune des faces du composant (13), afin d'éviter la refusion durant la seconde soudure, cette dernière continuant à être réalisée avec l'alliage étain/plomb, dont le point de fusion est de 183ºC.

## Description

La présente sollicitude de brevet d'invention consiste, conformément aux indications de l'énoncé, en des "AMELIORATIONS INTRODUITES DANS LE BREVET D'INVENTION N^{º} 9200325 comme PERFECTIONNEMENTS DANS LES PROCEDES DE FABRICATION DE BOITES DE SERVICES ET DE LEURS PARTIES", dont les nouvelles caractéristiques de construction, conformation et conception remplissent la mission pour laquelle elles ont été spécifiquement projetées, avec un maximum de sécurité et d'efficacité.

Le brevet d'invention n^{º} 9302193 du même titulaire décrit et revendique des améliorations dans les procédés de fabrication de boîtes de service et de leurs parties, le tout étant relatif à la patente principale n^{º} 9200325, dont l'objet sont des "PERFECTIONNEMENTS DANS LES PROCEDES DE FABRICATION DE BOITES DE SERVICES ET DE LEURS PARTIES". Ces améliorations consistent à utiliser des alliages spéciaux dans les opérations de soudure du type de celles qui correspondent à la formule 95 Sn, 5 Sb et 52 Sn, 45 Pb, 3 Sb, ainsi que l'application d'un nouveau matériel de substrat formé de fibres de verre sur la surface externe et de papier époxy sur la surface interne et, finalement, un vernis spécial formé d'un bain photosensible ou d'un liquide repoussant l'eau et préservant de la corrosion.

La pratique dans l'application de ces améliorations a introduit de nouveaux facteurs techniques et a mis à jour des phénomènes peu connus qui ont eu pour conséquence la création d'une nouvelle solution technique et un perfectionnement dans les technologies de fabrication des boîtes de service et de leurs parties sur lesquelles les processus de soudure représentent une part importante.

La fonction de la soudure est indispensable, car elle assure l'union électrique entre deux matériaux conducteurs, de sorte qu'elle évite de fortes chutes de tension, ce qui les maintient stables.

Mécaniquement parlant, la soudure possède également une fonction, car elle doit supporter les composants pour garantir le passage du courant. Cette union mécanique doit être résistante à :
- Des vibrations, des changements de température, l'humidité, la corrosion et autres.
   Communément, les soudures effectuées par bain de vague utilisent un alliage de plomb, avec des caractéristiques de :
- Point de fusion 183^{º}C, eutectique T₁ = T₂, conductivité électrique 11'50% du cuivre.

Pour obtenir une amélioration sur la soudure, en particulier pour les composants transversaux, soudés sur les deux faces du circuit imprimé, il faut recourir à des procédés de soudure de différentes caractéristiques sur chacune des extrémités des composants, de sorte que les deux soudures ne se voient pas qualitativement affectées entre elles. Pour éviter les conséquences, une solution a été trouvée et elle consiste à utiliser des alliages de soudure avec des points de soudure différents pour chacune des faces du composant, afin d'éviter la refusion durant la seconde soudure, cette dernière continuant à être réalisée avec l'alliage étain/plomb, dont le point de fusion est de 183^{º}C.

Dans le même temps, ce nouvel alliage doit offrir une meilleure résistance à la fatigue thermomécanique et pour cela les conditions suivantes sont exigées au nouvel alliage :
Eutectique T₁ = T₂.
183^{º}C < Tₜ < 200^{º}C
Améliorations des propriétés physiques.
Bonne soudabilité.
Exempt de plomb et autres éléments polluants.
Coût supportable.
Adaptable aux appareils de production actuels.

Parmi tous les alliages commerciaux disponibles pour la soudure par vague, le choix s'est porté sur un alliage binaire basé sur l'étain et l'argent qui remplissent les conditions précédentes.

Avec les essais réalisés sur les perfectionnements susmentionnés, l'on a obtenu l'amélioration par la combinaison des trois facteurs suivants :
La soudure Sn/Ag ne se refond pas.
La soudure Sn/Ag présente des propriétés mécaniques supérieures, ce qui lui confère une meilleure résistance à la fatigue thermomécanique.
La température de fusion plus élevée de la soudure Sn/Ag lui confère une meilleure résistance thermique face aux cycles de courant.

D'autres détails et caractéristiques de l'actuelle sollicitude de brevet d'invention seront soulignés au cours de la description qui est donnée ci-dessous et qui fait référence aux figures accompagnant ce mémoire dans lequel sont représentés les détails préférés. Ces détails sont donnés à titre d'exemple et se réfèrent à un cas possible de réalisation pratique, mais ne demeurent pas limités aux détails et composants qui y sont exposés ; cette description doit donc être considérée d'un point de vue illustratif et sans aucune sorte de limitations.

On trouvera ci-dessous une liste détaillée des divers éléments cités dans la présente sollicitude de brevet d'invention, (10) circuit imprimé, (11) substrat diélectrique, (12) couche de cuivre, (13) pin, (14) soudure, (14a) soudure extérieure, (14b) soudure intérieure, (15) soudure intérieure, (16) pin d'insertion.

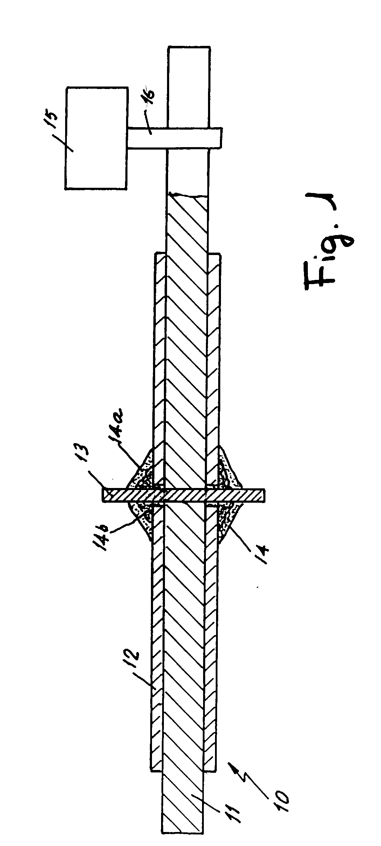

La figure unique est une section longitudinale en élévation d'un circuit imprimé (10).

Sur l'une des réalisations préférées de ce qui fait l'objet de la présente sollicitude et comme le montre la figure ci-jointe, le circuit imprimé (10) tel qu'il est connu est formé d'un substrat diélectrique (11) qui est lui-même recouvert sur les deux faces par un circuit conducteur (12) affecté par les pistes correspondantes obtenues par n'importe lequel des systèmes actuellement connus. Entre autres méthodes de mettre en contact la couche conductrice (12) supérieure avec la couche inférieure se trouve celle de l'insertion de pins (13) qui connectent électriquement la couche conductrice (12) supérieure avec la couche inférieure, produisant ensuite une soudure conventionnelle sur la soudure par vague, la soudure (14) en résultant.

Comme expliqué précédemment, lorsque se produit la soudure sur l'une des faces (12), une première soudure se forme qui, après avoir soudé le pin sur la face opposée, ramollit en partie ce qui avait déjà été soudé, formant deux soudures superposées qui sont représentées sur les dessins et se distinguent par les chiffres (14a) et (14b).
Pour éviter les inconvénients que cela représente, on a modifié le procédé de soudure par vague, de sorte que l'on utilise, sur la première soudure de la face des composants, un alliage dont le point de fusion est conforme aux caractéristiques du nouvel alliage Ag/Sn pour ensuite, dans une seconde opération sur l'autre face, produire la soudure par vague à l'aide d'un alliage d'étain-plomb avec un point de fusion de 183^{º}.

Le procédé susmentionné et l'utilisation de deux alliages différents permet d'éviter les effets indésirables sur les opérations de soudure décrites ci-dessus.

Le présent brevet d'invention ayant été suffisamment décrite en correspondance avec les plans ci-joints, il est entendu que toutes modifications de détail jugées opportunes pourront être introduites sur ceux-ci, à la condition de ne pas altérer l'essence de la patente qui se trouve résumée dans les REVENDICATIONS suivantes.

## Revendications

1. "AMELIORATIONS INTRODUITES DANS LE BREVET D'INVENTION N^{º} 9200325 comme PERFECTIONNEMENTS DANS LES PROCÉDÉS DE FABRICATION DE BOITES DE SERVICES ET DE LEURS PARTIES" de celles qui utilisent un alliage d'étain-plomb pour la soudure des composants électriques ou électroniques entre deux couvercles conducteurs (12) d'un circuit imprimé (10), caractérisées par le fait que, lesdits composants électriques ou électroniques ayant été insérés sur le circuit imprimé (10), on procède à une première opération de soudure sur la face des composants ou base supérieure de la couche conductrice (12) par le biais d'un alliage de Sn/Ag pour ensuite procéder à une seconde opération de soudure sur la face des soudures à l'aide d'un alliage de Sn/Pb.
